Europäisches Patentamt

European Patent Office

Office européen des brevets

(11) Veröffentlichungsnummer : **0 118 694**
**B1**

(12) **EUROPÄISCHE PATENTSCHRIFT**

(45) Veröffentlichungstag der Patentschrift :
19.08.87

(51) Int. Cl.⁴ : **G 01 N 24/06**, G 01 N 24/08

(21) Anmeldenummer : 84100721.4

(22) Anmeldetag : 24.01.84

(54) Gerät zur Erzeugung von Bildern eines Untersuchungsobjektes mit magnetischer Kernresonanz.

(30) Priorität : 09.02.83 DE 3304461

(43) Veröffentlichungstag der Anmeldung :
19.09.84 Patentblatt 84/38

(45) Bekanntmachung des Hinweises auf die Patenterteilung : 19.08.87 Patentblatt 87/34

(84) Benannte Vertragsstaaten :
DE FR GB NL

(56) Entgegenhaltungen :
GB-A- 1 603 560
GB-A- 2 052 069
GB-A- 2 070 254
US-A- 4 015 196
US-A- 4 296 378
JOURNAL OF APPLIED PHYSICS, Band 47, Nr. 48, August 1976, Seiten 3709-3721, New York, US; W.S.HINSHAW: "Image formation by nuclear magnetic resonance: The sensitive-point method"

(73) Patentinhaber : Siemens Aktiengesellschaft Berlin und München
Wittelsbacherplatz 2
D-8000 München 2 (DE)

(72) Erfinder : Loeffler, Wilfried, Dr.
Hintere Gasse 15
D-8522 Herzogenaurach (DE)

## Beschreibung

Die Erfindung betrifft ein Gerät zur Erzeugung von Bildern eines Untersuchungsobjektes mit magnetischer Kernresonanz, bei dem Magnetspulen zum Anlegen von Grund- und Gradientenfeldern an das Untersuchungsobjekt und zum Erfassen der Auslenkung der Atomkerne des Untersuchungsobjektes aus ihrer Gleichgewichtslage durch einen hochfrequenten magnetischen Anregungsimpuls vorhanden sind und das eine Bildrekonstruktionseinrichtung für ein Bild in einem vorbestimmten Meßfeld aufweist.

Es ist bekannt, daß man insbesondere die Wasserstoffatomkerne eines Untersuchungsobjektes aus einer Vorzugsrichtung, die durch ein Magnet-Grundfeld erzeugt wird, durch einen hochfrequenten Anregungsimpuls auslenken kann und daß sich die Atomkerne nach dem Ende dieses Anregungsimpulses aufgrund ihres Spins erst nach einer gewissen Zeit wieder in die Vorzugsrichtung einpendeln. Während dieser Zeit präzedieren die Atomkerne mit einer Frequenz, die von der Stärke des Magnet-Grundfeldes abhängt. Überlagert man diesem homogenen Magnet-Grundfeld einen Feldgradienten, so daß die Magnetfeldverteilung räumlich variiert, so ist eine Ortung über die jeweils gemessene Frequenz möglich. Es ist auch bekannt, daß man auf diese Weise und durch Änderung der Richtung des Feldgradienten Schichtbilder des Untersuchungsobjektes anfertigen kann. Die Anregung in einer Schicht des Untersuchungsobjektes erfolgt dabei dadurch, daß das Magnet-Grundfeld durch einen weiteren Feldgradienten so beeinflußt wird, daß nur in dieser Schicht eine Anregung der Atomkerne erfolgt. Dies ist möglich, weil die Anregung nur mit einer Frequenz erfolgt, die dem Magnetfeld in der gewünschten Schicht streng zugeordnet ist.

Bei bekannten Geräten der eingangs genannten Art entspricht der Homogenitätsbereich des Grundfeldmagneten dem Meßfeld, so daß das entstehende Bild alle Details des Meßfeldes mit der gleichen Auflösung und Genauigkeit wiedergibt. Häufig interessiert aber von dem entstehenden Bild nicht der gesamte Bereich, sondern nur ein Teil, insbesondere der mittlere Teil.

Der Erfindung liegt die Aufgabe zugrunde, ein Gerät der eingangs genannten Art so auszubilden, daß nicht das gesamte Bild mit der gleichen Auflösung und Genauigkeit wiedergegeben wird, sondern daß das erzeugte Bild einen diagnostisch auswertbaren Bereich aufweist, dem sich ein Bereich mit geringer Auflösung oder ein gänzlich unverwertbarer Bereich anschließt.

Diese Aufgabe ist erfindungsgemäß dadurch gelöst, daß der Homogenitätsbereich des Grundfeldmagneten innerhalb des Meßfeldes kleiner als das Meßfeld ist und daß das Gradientenfeld über das gesamte Meßfeld monoton verläuft. Bei dem erfindungsgemäßen Gerät wird zwar ein Bild erzeugt, das dem gesamten Meßfeld entspricht ; die Bereiche dieses Bildes, in denen das Feld des Grundfeldmagneten nicht homogen verläuft, sind jedoch nicht diagnostisch auswertbar. Wegen des monotonen Verlaufes des Gradientenfeldes im gesamten Meßfeld ergibt sich jedoch ein einwandfreier Bildbereich, der dem Teil des Meßfeldes entspricht, in dem das Grundfeld homogen verläuft, und der diagnostisch auswertbar ist. Aufgrund der geringen Abmessungen des Homogenitätsbereiches des Grundfeldes im Vergleich zum Meßfeld ergibt sich ein einfacherer Aufbau des Grundfeldmagneten als beim Stand der Technik.

Die Erfindung ist nachfolgend anhand der Zeichnung näher erläutert. Es zeigen :

Figur 1 eine Darstellung eines Gerätes zur Erläuterung des Erfindungsgedankens,

Figur 2 und 3 Darstellungen zur Erläuterung des Gerätes gemäß Figur 1, und

Figur 4 und 5 Feldverläufe zur Erläuterung des Erfindungsgedankens.

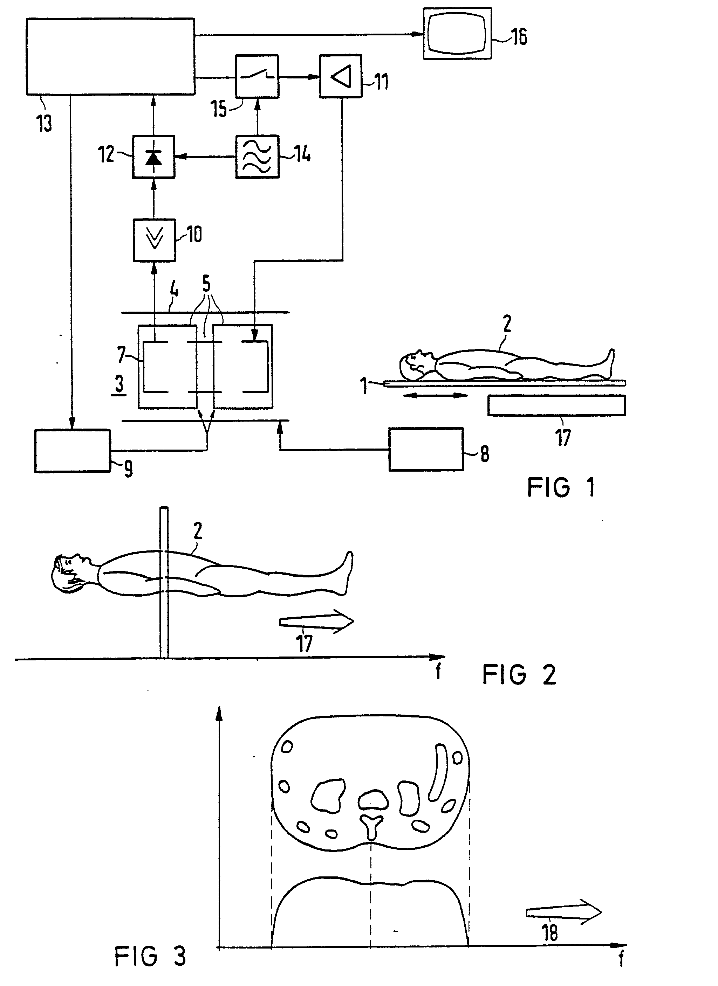

In der Figur 1 ist eine Auflage 1 dargestellt, auf der ein Patient 2 liegt, von dem mit Hilfe magnetischer Kernresonanz Bilder erzeugt werden sollen. Hierzu ist ein Spulensystem 3 mit einer Spule 4 zur Erzeugung eines homogenen Magnetfeldes, Gradientenspulen 5 zur Variierung dieses Magnetfeldes sowie mit einer Anregungs- und Meßspule 7 vorhanden. Die Spule 4 ist an einer Magnet-Stromversorgung 8, die Gradientenspulen 5 sind an einer Gradienten-Stromversorgung 9, die Anregungs- und Meßspule 7 ist an einem Vorverstärker 10 und über entsprechende Koppelelemente an einen Sendeverstärker 11 angeschlossen. Der Vorverstärker 10 führt das Meßsignal über einen phasenempfindlichen Gleichrichter 12 einem Prozeßrechner 13 zu, der den gesamten Meßvorgang steuert. Zur Erzeugung eines Anregungsimpulses dient ein Hochfrequenzoszillator 14, der über einen Modulator 15 an den Sendeverstärker 11 anschaltbar ist. Die Wiedergabe der erzeugten Bilder erfolgt auf einem Monitor 16.

Zur Erzeugung eines Bildes des Patienten 2 mit Hilfe magnetischer Kernresonanz wird die Auflage 1 mit Hilfe einer Steuervorrichtung 17, die ebenfalls vom Prozeßrechner 13 angesteuert wird, so in das Spulensystem 3 eingeschoben, daß in einer Schicht des Patienten 2 bei verschiedenen Gradientenfeldern durch Anregungsimpulse in der Spule 7 Kernresonanz angeregt wird. Aus den ebenfalls mit Hilfe der Spule 7 aufgenommenen Meßsignalen werden Informationen gebildet, mit denen der Prozeßrechner 13 ein Bild der untersuchten Schicht des Patienten 2 berechnet.

Die Figur 2 zeigt, daß die jeweils angeregte Schicht im Patienten 2 von der Ortsabhängigkeit der Flußdichte und damit der Kernresonanzfrequenz bestimmt wird. Der Feldgradient ist in der Figur 2 schematisch dargestellt und mit 17 bezeichnet. Die Resonanzfrequenz ist mit f bezeichnet. Es erfolgt dabei nur eine Anregung der Atomkerne im dargestellten Bereich des Patienten 2.

Die Figur 3 zeigt einen Querschnitt durch den angeregten Bereich des Patienten 2 und darunter den Verlauf der Signalamplitude des nach der Anregung gemessenen Signales in Abhängigkeit von der Kernresonanzfrequenz. Aufgrund des hier angewandten, schematisch dargestellten Feldgradienten 18 hängt hier die Signalamplitude derart von der Kernresonanzfrequenz ab, daß sich ein Verlauf ergibt, der eine Projektion der untersuchten Schicht des Patienten 2 auf die Richtung des Feldgradienten 18 darstellt. Durch Änderung der Richtung des Feldgradienten kann so eine Vielzahl solcher Projektionen erzeugt werden, die die Bildberechnung ermöglicht.

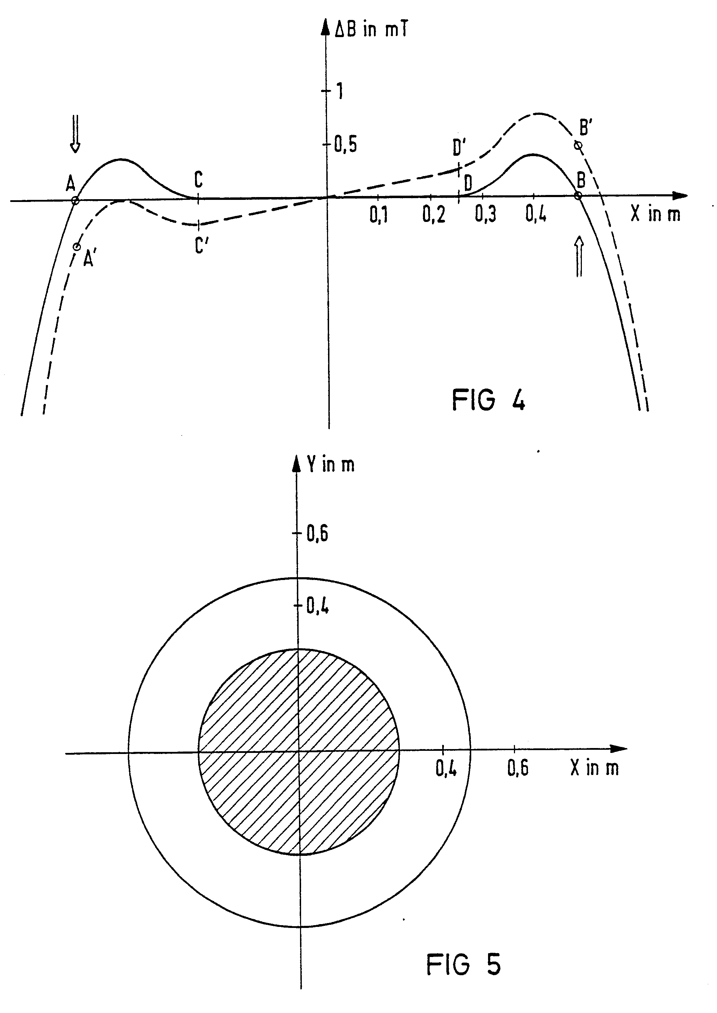

Die Figur 4 zeigt den Feldverlauf in x-Richtung, d. h. in Figur 2 senkrecht zur Zeichenebene und in Figur 3 in Richtung des Feldgradienten 18. Die voll ausgezogene Linie in Figur 4 stellt dabei den Verlauf des Grundfeldes dar, das durch den Feldgradienten 18 entsprechend der gestrichelten Linie in Figur 4 variiert wird. Die Figur 4 zeigt, daß das Grundfeld innerhalb des Meßfeldes, das durch die beiden Punkte A und B festgelegt ist, nicht homogen verläuft, sondern nur innerhalb des Bereiches zwischen den Punkten C und D. Der Feldgradient hingegen verläuft über das gesamte Meßfeld linear. Die selektive Anregung der gewünschten Schicht erfolgt durch einen geformten Hochfrequenzimpuls bei eingeschaltetem z-Gradienten. Hierdurch wird die Magnetisierung des untersuchten Körpers außer im Bereich C bis D auch bei A und B zur Präzession angeregt. Bei der Messung erhält man demgemäß im jeweils von der Spule 7 empfangenen Signal sowohl Anteile aus dem in der Figur 5 schraffiert gekennzeichneten Bereich des Meßfeldes als auch dem in der Figur 5 ringförmig diesen Bereich umgebenden äußeren Bereich. Die Figur 5 stellt dabei eine Darstellung des Meßfeldes dar, in der die untersuchte Transversalschicht des Patienten liegt. Die y-Richtung verläuft dabei in der Figur 2 in vertikaler Richtung. Durch die Monotonie der Gradientenfelder ist gewährleistet, daß beim Einschalten des x-Gradienten zum Auswerten einer Projektion (gestrichelte Linie in Fig. 4) das Feld und damit die Kernresonanzfrequenz an den Orten A (entsprechender Feldwert A') und B (entsprechender Feldwert B') außerhalb des Wertebereiches C' bis D' liegt und sich damit die Signalbeiträge aus diesen Gebieten rechnerisch abtrennen lassen.

Der Prozeßrechner 13 sorgt bei der Bildberechnung dafür, daß die äußeren Bildbereiche nicht durch Rückfaltung eine Störung des inneren ausnutzbaren, schraffierten Bildbereiches bewirken. Der Abbildungsmaßstab wird durch richtige Wahl der Gradientenfeldstärke und der Abtastzeiten so eingestellt, daß der gesamte in Figur 5 dargestellte Bereich überdeckt wird. Ausnutzbar ist selbstverständlich nur der innere, schraffierte Teil des entstehenden Bildes. Wegen der reduzierten Anforderungen an den Homogenitätsbereich des Grundfeldes kann der Grundfeldmagnet gemäß Figur 4 im Vergleich zum Stand der Technik einfacher ausgebildet sein.

**Patentansprüche**

1. Gerät zur Erzeugung von Bildern eines Untersuchungsobjektes (2) mit magnetischer Kernresonanz, bei dem Magnetspulen (4, 5, 7) zum Anlegen von Grund- und Gradientenfeldern an das Untersuchungsobjekt (2) und zum Erfassen der Auslenkung der Atomkerne des Untersuchungsobjektes (2) aus ihrer Gleichgewichtslage durch einen hochfrequenten magnetischen Anregungsimpuls vorhanden sind und das eine Bildrekonstruktionseinrichtung (13) für ein Bild in einem vorbestimmten Meßfeld aufweist, dadurch gekennzeichnet, daß der Homogenitätsbereich des Grundfeldmagneten (4) innerhalb des Meßfeldes (A, B) kleiner als das Meßfeld ist und daß das Gradientenfeld über das gesamte Meßfeld monoton verläuft.

2. Gerät nach Anspruch 1, dadurch gekennzeichnet, daß das Gradientenfeld über das gesamte Meßfeld linear verläuft.

3. Gerät nach Anspruch 1, dadurch gekennzeichnet, daß zum Anregen der Kernresonanz geformte Hochfrequenzimpulse bei eingeschaltetem Feldgradienten in der zur gewünschten Schicht senkrechten Richtung verwendet werden.

**Claims**

1. Nuclear magnetic resonance apparatus for producing images of an object (2) to be investigated, where magnetic coils (4, 5, 7) are provided to apply fundamental fields and gradient fields to the object (2) to be investigated, and which serve to detect deflection of the atomic cores of the object (2) to be investigated out of their equilibrium position using a magnetic, high-frequency excitation pulse, and comprising an image reconstruction device (13) which reproduces an image in a predetermined measurement field, characterised in that the homogeneity range of the fundamental field magnet (4) within the measurement field (A, B) is smaller than the measurement field, and that the gradient field extends monotonically over the entire measurement field.

2. A device as claimed in Claim 1, characterised in that the gradient field extends linearly over the entire measurement field.

3. A device as claimed in Claim 1, characterised in that high-frequency pulses, shaped to excite core resonance, are employed in the direction at right angles to the required plane when the field gradient is connected.

**Revendications**

1. Appareil pour produire des images d'un objet d'examen (2) par résonance magnétique nucléaire, et dans lequel il est prévu des bobines magnétiques (4, 5, 7) servant à appliquer un champ de base et un champ irrotationnel à l'objet d'examen (2) et à produire une excursion des noyaux atomiques de l'objet d'examen (2) à partir de leur position d'équilibre au moyen d'une impulsion d'excitation magnétique à haute fréquence, et qui comporte un dispositif (13) de reconstitution des images pour une image dans une zone de mesure prédéterminée, caractérisé par le fait que la zone d'homogénéité du champ magnétique de base (4) à l'intérieur de la zone de mesure (A, B) est plus petite que la zone de mesure et que le champ irrotationnel possède une variation monotone dans l'ensemble de la zone de mesure.

2. Appareil suivant la revendication 1, caractérisé par le fait que le champ irrotationnel possède une variation linéaire sur l'ensemble de la zone de mesure.

3. Appareil suivant la revendication 1, caractérisé par le fait que l'on utilise des impulsions à haute fréquence formées pour réaliser l'excitation de la résonance nucléaire lorsque le gradient de champ est établi dans la direction perpendiculaire à la couche désirée.

FIG 1

FIG 2

FIG 3

FIG 4

FIG 5

2